# FASCICULE DE BREVET EUROPEEN

(11) **EP 0 506 531 B1**
(45) Date de publication et mention de la délivrance du brevet: **27.09.1995**
(21) Numéro de dépôt: 92400761.0
(22) Date de dépôt: 20.03.1992
(51) Int. Cl.: G01R 19/165

(54) **Circuit de détection d'un seuil haut d'une tension d'alimentation**
Schaltung zur Überwachung eines oberen Schwellwertes einer Versorgungsspannung
High threshold detection circuit for power supply

(30) Priorité: 28.03.1991 FR 9103766
(43) Date de publication de la demande: 30.09.1992
(73) Titulaire: SGS-THOMSON MICROELECTRONICS S.A., 94250 Gentilly (FR)
(72) Inventeur: Fournel, Richard, Cabinet Ballot-Schmit, F-75116 Paris (FR)
(74) Mandataire: Schmit, Christian Norbert Marie

(56) Documents cités:
- FR-A- 2 613 491
- US-A- 4 658 156
- ELEKTRONIK, no. 22, novembre 1981, pages 57-62, Munich, DE; D. CHANDRA et al.: "Über- und Unterspannungs- Überwachungsschaltungen"
- PATENT ABSTRACTS OF JAPAN, vol. 8, no. 125 (P-279)[1562], 12 juin 1984;
- ELECTRONIC DESIGN, vol. 37, no. 20, 28 septembre 1989, pages 94-95, Cleveland, US; M. JACHOWSKI: "Monitor supplies down to 0.6 V"

## Description

L'invention a pour objet un détecteur d'un seuil haut de la tension d'alimentation d'un circuit intégré. Elle s'applique en particulier aux circuits intégrés sécurisés, par exemple les circuits intégrés destinés à des applications bancaires.

On connaît de manière fiable le fonctionnement d'un circuit intégré, à condition que chacun de ses signaux de commande prenne des valeurs au cours du temps qui soient toujours à l'intérieur d'un gabarit déterminé. En particulier, la tension d'alimentation Vcc doit toujours avoir une valeur inférieure à un seuil haut. Si ce seuil est dépassé, on peut obtenir un fonctionnement incontrôlé du circuit intégré. Par exemple des accès anormaux à des données protégées du circuit intégré peuvent se produire avec une tension d'alimentation Vcc anormalement haute (hors gabarit supérieur). Un fraudeur pourrait alors avoir la possibilité de modifier, par exemple, les informations d'une carte bancaire à microprocesseur.

Pour empêcher de tels fonctionnements parasites rendant possible des fraudes, on a recours à un détecteur de seuil haut intégré dans le circuit à sécuriser et qui permet par exemple, le verrouillage des accès au circuit, ou à la mémoire qu'il contient, dès qu'il détecte que la tension Vcc dépasse un seuil déterminé. Comme les circuits intégrés peuvent fonctionner dans des plages étendues de température, par exemple dans une plage de température de -40° à +85°, il faut que le seuil de détection reste sensiblement invariant et aussi invariant que possible avec les procédés de fabrication du détecteur intégré.

Or, dans les détecteurs connus le seuil de détection varie beaucoup avec la température et les procédés de fabrication. Dans certains cas, on arrive à compenser certaines variations, comme par exemple avec le détecteur décrit dans la demande de brevet français FR 89 16650 de la demanderesse (publiée le 21.06.91 soit après la date de la priorité de la présente demande). Dans cet exemple, le détecteur est composé de manière classique d'un diviseur résistif de tension suivi d'un inverseur CMOS. La branche supérieure du diviseur, entre Vcc et le noeud de sortie du diviseur, comporte un transistor P, en série avec un premier transistor N. La branche inférieure, entre le noeud de sortie et la masse, comporte un deuxième transistor N. Les transistors N et P sont montés en diode et polarisés en direct. Dans cette structure, le premier transistor N a pour fonction de compenser les variations avec la température du transistor N de la branche inférieure du diviseur : les deux transistors N sont technologiquement identiques (même dimension, même tension de seuil).

Cependant, du fait des variations technologiques avec les procédés, et en tenant compte des variations de température, cette compensation n'est pas suffisante pour maintenir stable le seuil de détection d'un détecteur à l'autre et dans la plage de température -40 à +85°C.

En effet, dans un exemple de fabrication d'un tel détecteur un transistor N a un seuil typique à 0°C égal à 0,833 volts. En pratique, on obtient des valeurs allant de 0,697 (Vtnₘᵢₙ) à 0,978 volts (Vtnₘₐₓ), soit un écart absolu de l'ordre de 200 à 300 millivolts. Un transistor P a un seuil typique à 0°c égal à -1,103 volts. En pratique, on obtient des valeurs allant de -1,206 volts (Vtpₘᵢₙ) à -1,016 volts (Vtpₘₐₓ). Soit un écart absolu de l'ordre de 200 millivolts.

Avec ces variations de tension de seuil dites technologiques et les variations de tension de seuil avec la température on obtient ainsi dans un exemple, si on note Vo le seuil de détection :
- à 85°C pour (Vtn, Vtp) = (0,697, -1,206)
   Vo = 5,18 volts
- à -40°C pour (Vtn, Vtp) = (0,978, -1,016)
   Vo = 8,85 volts

soit un écart de l'ordre de 3,5 volts pour la plage de température considérée. Toutes les valeurs de tension de seuil Vtn et Vtp sont données à 0°C.
Dans des circuits sécurisés pour lesquels il faut respecter au mieux un gabarit déterminé, un tel détecteur n'est pas assez fiable.

Le document FR-A- 2 613 491 divulgue également un tel dispositif.

Dans l'invention, on cherche à s'affranchir des problèmes de variations technologiques d'un détecteur à l'autre.

Dans l'invention, on cherche à réduire la variation du seuil de détection avec la température.

Dans l'invention, on utilise une diode zener dans la branche supérieure du diviseur, avec un seuil de diode zener Vz légèrement supérieur à une valeur nominale de la tension à surveiller Vcc. Tant que Vcc est inférieure à Vz, le noeud de sortie du diviseur est à zéro volts. Dès que Vcc dépasse le seuil zener, la diode laisse passer beaucoup de courant. Elle a une tension de l'ordre de Vz à ses bornes et la branche inférieure du diviseur a donc à ses bornes la différence Vcc-Vz. L'inverseur CMOS est calibré pour basculer à une valeur de Vcc-Vz correspondant à la valeur de Vcc maximale (seuil haut) que l'on veut autoriser, de l'ordre de 6 volts.

Un objet de l'invention est donc un circuit de détection de seuil haut d'une tension à surveiller comportant un diviseur de tension pour commander en tension le basculement d'un inverseur, le diviseur comprenant une branche supérieure entre la tension à surveiller et un noeud de sortie du diviseur et une branche inférieure avec un élément résistif entre le noeud de sortie et une masse du circuit le noeud de sortie étant connecté à l'entrée de l'inverseur, circuit de détection caractérisé en ce que la branche supérieure comporte une diode zener montée en inverse entre la tension à surveiller et le noeud de sortie du diviseur. D'autres caractéristiques et avantages de l'invention sont présentés à titre indicatif et non limitatif dans la description qui suit et en référence au dessin annexé dans lequel :

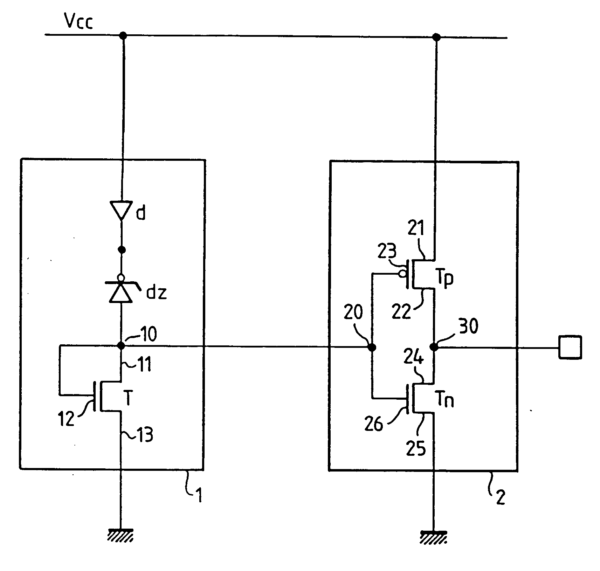

FIG.1 est un schéma électrique d'un détecteur selon l'invention.
Un détecteur selon l'invention (FIG.1) comporte un diviseur 1 suivi en série d'un inverseur 2.

Le diviseur 1 comporte :
- entre Vcc et un noeud de sortie 10 du diviseur, une diode zener dz dont la cathode est reliée à Vcc;
- entre le noeud de sortie 10 et la masse, un transistor T, de type N dans l'exemple avec un drain 11, une grille 12 et une source 13. Le drain 11 est relié d'une part au noeud 10 et d'autre part à la grille 12, tandis que la source 13 est reliée à la masse. Ainsi monté, le transistor T fonctionne en mode résistif. Le transistor T pourrait être remplacé par une résistance.

L'inverseur 2, est dans l'exemple, de type CMOS et comprend donc de manière connue :
- un transistor de type P, Tp, dont la source 21 est reliée à Vcc, le drain 22 est relié au point de sortie 30 de l'inverseur, et la grille 23 est reliée au point d'entrée 20 de l'inverseur;
- un transistor de type N, Tn, dont le drain 24 est relié au noeud de sortie 30 de l'inverseur, la source 25 est reliée à la masse et la grille 26 est reliée au point d'entrée 20 de l'inverseur.

La diode zener est choisie avec un seuil de tension Vz légèrement supérieure à une valeur nominale de la tension à surveiller (Vcc) et l'inverseur est calculé (géométrie et dopage des transistors) pour basculer à une valeur de tension de Vcc déterminée, supérieure au seuil de diode.

Tant que la tension Vcc est inférieure au seuil de diode Vz, aucun courant ne circule dans le diviseur et le noeud de sortie 10 du diviseur est à zéro volts. L'inverseur CMOS dont le fonctionnement est bien connu, délivre alors sur son point de sortie 30, un niveau haut de tension (Vcc).

Quand la tension Vcc dépasse le seuil de diode Vz, elle se met à conduire et appelle tout de suite beaucoup de courant. La tension aux bornes de la diode va alors s'établir à Vz et le transistor N qui fonctionne en mode résistif (car monté en diode polarisée en direct) va alors absorber à ses bornes la différence Vcc-Vz. Ainsi le noeud de sortie 10 du diviseur est porté au potentiel Vcc-Vz. Si on note Vo le seuil de détection, c'est à dire la valeur maximum de tension Vcc définie dans un gabarit, alors l'inverseur est tel qu'il bascule quand son noeud d'entrée 20 est porté au potentiel Vo-Vz : la sortie 30 de l'inverseur est alors portée au potentiel nul.

Un tel dispositif est avantageusement stable en température et en fabrication . En effet, la diode zener a une tension de seuil Vz qui varie beaucoup moins en fabrication et avec la température que celles des transistors. Dans un exemple, la tension de seuil Vz a une valeur typique à 25°C de 5,31 volts qui varie par exemple avec le procédé entre 5,26 et 5,42 volts. La variation en température de la tension de seuil Vz pour une valeur donnée est de l'ordre de 80 mv entre -40 et +85°C. Il faut cependant tenir compte de l'évolution de la réponse de l'inverseur CMOS. En effet, il est lui aussi composé de transistors MOS, et donc lui-même soumis à des variations technologiques et de température. Par exemple la valeur de Vcc à laquelle il bascule peut-être de 6 volts à 85°C, 5,85 volts à 25°C et 5,25 volts à -40°C.
Globalement dans un exemple, pour un seuil haut Vo de 6 volts, en tenant compte des variations technologiques et de température, on obtient avec le dispositif de l'invention les résultats suivants :
- Vo_{réel}=5,60 volts à 85°C
   pour (Vz, Vtn, Vtp,) = (5,26; 0,697; - 1,206)
- Vo_{réel}= 6,20 volts à -40°C
   pour (Vz, Vtn, Vtp) = (5,42; 0,998; - 1,016)

Soit un écart absolu entre les deux seuils de détection de 0,60 volts. Pour un seuil haut Vo de 6,5 volts, on obtient le même ordre de grandeur.
Ainsi d'un détecteur à l'autre (Vtn, Vtp, Vz différents) et pour différentes températures, on est sûr de pouvoir respecter le gabarit supérieur (6 volts) dans l'exemple à au moins ±0,4 volts près. Ainsi, un tel détecteur peut être intégré et utilisé de façon fiable dans les circuits sécurisés.

Un perfectionnement consiste à disposer une diode d polarisée en direct (cathode reliée à la cathode de la diode zener et anode reliée à Vcc), en série avec la diode zener. Elle permet de compenser un peu les variations de tension de seuil zener avec la température et de réduire encore les variations relatives du seuil de détection du dispositif.

## Revendications

1. Circuit de détection de seuil haut (Vo) d'une tension d'alimentation (Vcc) comportant un diviseur de tension (1) en série avec un inverseur, chacun alimenté entre la tension d'alimentation et une masse du circuit, le diviseur (1) comprenant un élément résistif (T) entre un noeud de sortie, connecté en entrée de l'inverseur, et la masse du circuit, caractérisé en ce que le diviseur comporte une diode zener (dz) montée en inverse entre la tension d'alimentation et le noeud de sortie du diviseur pour commander en tension le basculement de l'inverseur, la diode zener (dz) ayant une tension de seuil (Vz) supérieure à une valeur nominale de la tension d'alimentation (Vcc) et inférieure au seuil haut (Vo) du circuit de détection.

2. Circuit de détection selon la revendication 1, caractérisé en ce que l'élément résistif est un transistor MOS (T) monté en diode et polarisé en direct.

3. Circuit de détection selon la revendication 1, caractérisé en ce que l'élément résistif est une résistance.

4. Circuit de détection selon l'une quelconque des revendications 1 à 3, caractérisé en ce qu'une diode (d) polarisée en direct est montée en série entre la tension d'alimentation et la diode zener (dz), pour compenser les variations de la tension de seuil (Vz) de la diode zener.

5. Circuit intégré caractérisé en ce qu'il comporte un circuit de détection de seuil haut selon l'une quelconque des revendications 1 à 4, pour surveiller une tension d'alimentation du circuit intégré.

## Patentansprüche

1. Schaltung zur Erfassung eines oberen Schwellenwerts (Vo) einer Versorgungsspannung (Vcc), umfassend einen Spannungsteiler (1) in Reihe mit einem Umkehrschalter, deren jeder zwischen der Versorgungsspannung und einer Masse der Schaltung liegend gespeist wird, wobei der Teiler (1) ein Widerstandselement (T) zwischen einem Ausgangsknoten, der mit dem Eingang des Umkehrschalters verbunden ist, und der Masse der Schaltung aufweist, dadurch gekennzeichnet, daß der Teiler eine Zenerdiode (dz) umfaßt, die in Gegenrichtung zwischen der Versorgungsspannung und dem Ausgangsknoten des Teilers angeordnet ist, um mittels Spannung das Kippen des Umkehrschalters zu steuern, wobei die Zenerdiode (dz) eine Schwellenspannung (Vz) aufweist, die größer als ein Nominalwert der Versorgungsspannung (Vcc) und kleiner als der obere Schwellenwert (Vo) der Erfassungsschaltung ist.

2. Schaltung zu Erfassung nach Anspruch 1, dadurch gekennzeichnet, daß das Widerstandselement ein in Diodenschaltung angeordneter und in Vorwärtsrichtung betriebener MOS-Transistor (T) ist.

3. Schaltung zur Erfassung nach Anspruch 1, dadurch gekennzeichnet, daß das Widerstandselement ein Widerstand ist.

4. Schaltung zur Erfassung nach einem der vorangehenden Ansprüche 1 bis 3, dadurch gekennzeichnet, daß eine in Vorwärtsrichtung betriebene Diode (d) in Reihe zwischen der Versorgungsspannung und der Zenerdiode (dz) angeordnet ist, um die Schwankungen der Schwellenspannung (Vz) der Zenerdiode auszugleichen.

5. Integrierte Schaltung, dadurch gekennzeichnet, daß sie zum Überwachen einer Versorgungsspannung der integrierten Schaltung eine Schaltung zur Erfassung eines oberen Schwellenwerts nach einem der Ansprüche 1 bis 4 umfaßt.

## Claims

1. Circuit for detecting the upper threshold (Vo) of a supply voltage (Vcc) having a voltage divider (1) in series with an inverter, each supplied between the supply voltage and an earth of the circuit, the divider (1) comprising a resistive element (T) between an output node, connected at the input to the inverter, and the earth of the circuit, characterised in that the divider has a Zener diode (dz) inverse-mounted between the supply voltage and the output node of the divider in order to control the voltage of the switching of the inverter, the Zener diode (dz) having a threshold voltage (Vz) higher than a nominal value of the supply voltage (Vcc) and lower than the upper threshold (Vo) of the detection circuit.

2. Detection circuit according to Claim 1, characterised in that the resistive element is an MOS transistor (T), mounted as a diode and direct biased.

3. Detection circuit according to Claim 1, characterised in that the resistive element is a resistor.

4. Detection circuit according to any one of Claims 1 to 3, characterised in that a direct-biased diode (d) is mounted in series between the supply voltage and the Zener diode (dz), in order to compensate for variations in the threshold voltage (Vz) of the Zener diode.

5. Integrated circuit characterised in that it includes an upper threshold detection circuit according to any one of Claims 1 to 4, for monitoring a supply voltage of the integrated circuit.
